# EUROPÄISCHE PATENTSCHRIFT

(11) **EP 2 553 719 B1**
(45) Veröffentlichungstag und Bekanntmachung des Hinweises auf die Patenterteilung: **04.12.2019**
(21) Anmeldenummer: 10715497.3
(22) Anmeldetag: 31.03.2010
(51) Int. Cl.: H01L 21/683, H01L 21/98, H01L 21/48, H01L 25/065, H01L 23/538

(54) **VERFAHREN ZUR HERSTELLUNG EINES MIT CHIPS BESTÜCKTEN WAFERS MIT HILFE VON ZWEI SELEKTIV ABTRENNBAREN TRÄGERWAFERN MIT RINGFÖRMIGEN ADHÄSIONSSCHICHTEN MIT UNTERSCHIEDLICHEN RINGBREITEN**
METHOD FOR PRODUCING A WAFER PROVIDED WITH CHIPS USING TWO SEPARATELY DETACHABLE CARRIER WAFERS WITH RING-SHAPED ADHESIVE LAYERS OF DIFFERENT RING WIDTHS
PROCÉDÉ DE FABRICATION D'UNE TRANCHE POURVUE DE PUCES À L'AIDE DE DEUX TRANCHES DE SUPPORT SÉPARÉMMENT DÉTACHABLES AVEC DES COUCHES ANNULAIRES D'ADHÉSION À DIFFÉRENTES LARGEURS D'ANNEAU

(43) Veröffentlichungstag der Anmeldung: 06.02.2013
(73) Patentinhaber: Ev Group E. Thallner GmbH, 4782 St. Florian am Inn (AT)
(72) Erfinder: BURGGRAF, Jürgen, 4780 Schärding/Inn (AT); WIMPLINGER, Markus, 4910 Ried im Innkreis (AT); WIESBAUER, Harald, 4950 Altheim (AT)
(74) Vertreter: Schweiger, Johannes
(86) Internationale Anmeldenummer: PCT/EP2010/002055
(87) Internationale Veröffentlichungsnummer: WO 2011/120537

(56) Entgegenhaltungen:
- WO-A1-97/39481
- WO-A1-2005/057651
- WO-A1-2009/115240
- WO-A2-2004/006296
- AT-A2- 503 053
- US-A1- 2004 056 344
- US-A1- 2004 188 861
- US-A1- 2005 029 224
- US-A1- 2007 075 421
- US-A1- 2008 003 780
- US-A1- 2008 280 422
- US-B1- 7 232 740

## Beschreibung

Die vorliegende Erfindung betrifft ein Verfahren zur Herstellung eines Produktwafers gemäß Patentanspruch 1.

Die weit überwiegende Zahl der heute produzierten Wafer sind nur einseitig mit Chips beziehungsweise so genannten Dices bestückt. Die Bestückung der Wafer erfolgt in Massenfertigung und gleichzeitig besteht die Forderung der Industrie, immer kleinere Strukturen zu realisieren. Dies gilt auch für die Dicke des Wafers, insbesondere bei mehrfach gestapelten, mehrlagigen Wafern.

Die weitere optimale Ausnutzung des zur Verfügung stehenden Raums führt dazu, dass in letzter Zeit immer mehr doppelseitige, also auf beiden Seiten mit Chips beziehungsweise mit Dices bestückte Wafer gefordert werden, wobei Through Silicon Vias (TSVs) elektrische Kontakte zwischen der Vorder- und der Rückseite des Produktwafers ermöglichen können.

Das größte Problem bei der Herstellung solcher doppelseitiger Wafer besteht in der Handhabung während der Massenfertigung, die verschiedene Produktionsschritte umfassen kann, wie beispielsweise Bonding, Debonding, Ausrichtung, Schleifen, Ätzen und vieles mehr. Besonders wegen der im Produktionsprozess vorgesehenen Dünnung/Rückdünnung des Produktwafers ist eine Stabilisierung des großflächigen, meist einen Durchmesser von 300 Millimeter aufweisenden Produktwafers durch einen Trägerwafer erforderlich.

Die Stabilisierung beziehungsweise Unterstützung durch einen Trägerwafer bei einseitig bestückten Wafern stellt sich schon deshalb vergleichsweise einfach dar, da der Trägerwafer auf der von der mit Chips bestückten Seite abgewandten Seite temporär gebondet werden kann. Auch hier können aber Prozessschritte auf der Vorder- und Rückseite erforderlich sein.

Im Allgemeinen besteht beim temporären Bonden das Problem, den verschiedene Produktionsschritte durchlaufenen Produktwafer nach Abschluss dieser Produktionsschritte schonend und zerstörungsfrei vom Trägerwafer abzulösen. Die Verbindung zwischen dem Trägerwafer und dem Produktwafer muss demnach während der Anwendung verschiedener Produktionsschritte stark genug sein, um den Produktwafer zu stabilisieren und zu halten. Gleichzeitig sollte die Verbindung aber anschließend einfach und schnell lösbar sein.

Die WO 2009/094558 A2 beschreibt ein temporäres Bondverfahren für einen einseitig bestückten Produktwafer.

Die WO 2009/115240 A1 offenbart ein Verfahren zur Herstellung eines mit Chips bestückten Produktwafers mit folgendem Ablauf: Bestücken einer ersten Seite des Produktwafers mit Chips; Bonden der mit Chips bestückten ersten Seite des Produktwafers auf einem starren Trägerwafer; Rückdünnen des Produktsubstrats von seiner zweiten Seite; Bestücken der zweiten Seite des Produktwafers mit Chips; Eingießen der Chips auf der zweiten Seite des Produktwafers in einer Masse (z.B. Epoxidharz); und Abtrennen des Trägerwafers. Alternativ offenbart die WO 2009/115240 A1 ein Verfahren zur Herstellung eines mit Chips bestückten Produktwafers mit folgendem Ablauf: Bestücken einer ersten Seite des Produktwafers mit Chips; Bonden der mit Chips bestückten ersten Seite des Produktwafers auf einer Rückdünnfolie; Rückdünnen des Produktwafers von seiner zweiten Seite; Bonden der zweiten Seite des Produktsubstrats auf einem starren Träger; Abtrennen der Rückdünnfolie; Stapeln weiterer Chips auf den sich auf der ersten Seite des Produktwafers befindenden Chips; und Abtrennen des Trägers.

Die US 2004/056344 A1 offenbart ein Verfahren zur Herstellung eines doppelseitig mit Chips bestückten Produktsubstrats mit folgendem Ablauf: Ausbilden eines Produktsubstrats auf einem ersten, starren Träger; Bestücken einer ersten Seite des Produktsubstrats mit Chips; Bonden des Produktsubstrats mit seiner ersten Seite auf einem zweiten, starren Träger; Abtrennen des ersten Trägers; Bestücken einer zweiten Seite des Produktsubstrats mit Chips; und Abtrennen des zweiten Trägers.

Die gattungsgemäßen Verfahren haben demnach gemein, dass jeder Produktwafer im Herstellungsprozess auf jeder Seite mindestens einem Bearbeitungsschritt ausgesetzt werden muss. Die Produktwafer werden heute wegen der einfacheren Handhabung zunächst bei ihrer Ausgangsdicke, also vor dem Rückdünnen, auf ihrer ersten Seite bearbeitet, beispielsweise das Herstellen von Bumps beziehungsweise Aufbringen von Bumps oder Bumpgruppen. Anschließend wird der Produktwafer auf einen Träger gebondet, um den Produktwafer daraufhin dem Bearbeitungsschritt des Rückdünnens unterziehen zu können. Nach dem Rückdünnen werden dann in der Regel weitere Bearbeitungsschritte auf der zweiten Seite durchgeführt, beispielsweise wiederum das Herstellen von Bumps und/oder Bumpgruppen und/oder anderen Verbindungslayern und/oder das Aufbringen von Chips. Soweit nach der Bearbeitung der zweiten Seite nun nochmals ein Bearbeitungsschritt auf der ersten Seite des Produktwafers erforderlich ist, besteht im Stand der Technik das große Problem, dass der gedünnte und sehr empfindliche, teilweise schon mit teuren Chips versehene Produktwafer von dem Träger gelöst werden muss, um die erste Seite für weitere Bearbeitungsschritte zugänglich zu machen.

Der vorliegenden Erfindung liegt die Aufgabe zugrunde, ein Verfahren zur Herstellung eines, insbesondere doppelseitig mit Chips bestückten, Produktwafers anzugeben, durch welches der Produktwafer während des Fertigungsprozesses sicher und schonend gehandhabt werden kann. Diese Aufgabe wird mit den Merkmalen des Anspruchs 1 gelöst. Vorteilhafte Weiterbildungen der Erfindung sind in den Unteransprüchen angegeben. Bei angegebenen Wertebereichen sollen auch innerhalb der genannten Grenzen liegende Werte als Grenzwerte offenbart und in beliebiger Kombination beanspruchbar sein.

Grundidee der vorliegenden Erfindung ist es, ein Verfahren vorzusehen, mit dem die beiden mit dem jeweiligen Produktwafer verbundenen beziehungsweise gebondeten, starren Trägerwafer selektiv gelöst werden können wodurch ein Transfer des Produktwafers von dem ersten auf den zweiten Trägerwafer ermöglicht wird, währenddessen der Produktwafer ständig stabilisiert wird. Dies wird erreicht, indem die Verbindungsschichten der beiden Trägerwafer unterschiedliche Eigenschaften hinsichtlich ihrer Adhäsion und/oder ihrer Adhäsionsänderung bei Einwirkung auf die Verbindungsschicht, insbesondere zusätzlich durch mechanische, thermische und/oder chemische Verfahren haben. Wesentlich ist es dabei, dass durch die unterschiedlichen Eigenschaften der beiden Zwischenschichten eine der beiden Zwischenschichten selektiv gegenüber der anderen Zwischenschicht derart ausgebildet ist und optional zusätzlich verändert werden kann, dass diese Zwischenschicht gelöst werden kann, während die andere Zwischenschicht ihre Bondkraft zumindest deutlich stärker als die Bondkraft der anderen Zwischenschicht aufrechterhält. Die Adhäsion ist jeweils bezogen auf die wirksame Fläche der Verbindungsschicht.

Grundsätzlich funktioniert das erfindungsgemäße, selektive Ablösen und/oder Abtrennen immer durch unterschiedliche Adhäsionskräfte zwischen den Trägerwafern und dem Produktwafer, wobei sich die Adhäsionskraft erfindungsgemäß auf die Gesamtheit der Zwischenschicht zwischen dem jeweiligen Trägerwafer und dem Produktwafer bezieht.

Erfindungsgemäß sind die zwischen den Trägerwafern und dem Produktwafer wirkenden Adhäsionskräfte inhärent, das heißt von Beginn an, unterschiedlich. Die Zwischenschichten weisen also von Beginn an unterschiedliche Haftkräfte auf, was zum einen dadurch erreicht wird, indem die Zwischenschichten aus einem unterschiedlichen Material bestehen oder die Kontaktflächen der Zwischenschichten zum jeweiligen Trägerwafer und/oder zum Produktwafer vorbehandelt werden, um Einfluss auf die an den jeweiligen Kontaktflächen wirkenden Kräfte zu nehmen. Eine denkbare Ausführungsform der Erfindung sieht dabei zusätzlich vor, entweder haftungsmindernde Substanzen oder haftungsfördernde Substanzen zu verwenden, um die Oberfläche des Trägerwafers ganz oder teilweise zu behandeln und/oder die Oberfläche des Produktwafers ganz oder teilweise zu behandeln. Es bestehen die nachfolgenden, in Kombination mit der erfindungsgemäß beanspruchten unterschiedlichen Größe der Kontaktfläche (unterschiedlicher Ringbreite der Zwischenschicht) anwendbaren Varianten:
- unterschiedliches Klebematerial der Zwischenschichten
- unterschiedliche Vorbehandlung zumindest einer Oberfläche/Kontaktfläche (ganz oder teilweise) mit
   ▪ haftungsmindernder Substanz oder
   ▪ haftungsfördernder Substanz
- unterschiedliche Dicke der Zwischenschicht.

Gemäß einer weiteren Gruppe von erfindungsgemäßen Verfahrensvarianten ist vorgesehen, dass zusätzlich durch bestimmte Maßnahmen eine indizierte Veränderung der Adhäsionskräfte der Zwischenschichten vorgenommen wird. Es wird hierbei zu einem wählbaren, definierten Zeitpunkt die Adhäsionskraft einer der beiden Zwischenschichten oder beider Zwischenschichten derart verändert, dass die Adhäsionskräfte der beiden Zwischenschichten nach der indizierten Veränderung der Adhäsionskraft unterschiedlich sind. Erfindungsgemäß sind dabei folgende Möglichkeiten vorgesehen:
- Gezielte örtliche Einwirkung, insbesondere durch Bestrahlen von einer Zwischenschicht, während die andere Zwischenschicht nicht oder nur teilweise bestrahlt wird. Die gezielte örtliche Einwirkung ist in einer anderen Ausgestaltung der Erfindung durch Einwirkung von Lösungsmitteln auf nur eine Zwischenschicht möglich, während die andere Zwischenschicht nicht oder nur teilweise mit Lösungsmitteln beaufschlagt wird.
- Selektivität durch Materialwahl und zumindest teilweise inertes Verhalten einer Zwischenschicht zu dem angewendeten Verfahrensschritt, der die Veränderung der anderen Zwischenschicht verursacht, insbesondere durch eine Temperaturerhöhung bei dem eine der beiden Zwischenschichten mit einem weniger stark ausgeprägten Abfall der Viskosität reagiert, wodurch diese Zwischenschicht eine stärkere Bondkraft gegen Scherkräfte aufweist. Besonders bevorzugt ist es hierbei, eine der beiden Zwischenschichten inert gegenüber einem Lösungsmittel auszubilden, während es die andere Zwischenschicht auflöst.
- Änderung der Adhäsionskraft der ersten Zwischenschicht, indem auf die erste Zwischenschicht eingewirkt wird, bevor die zweite Zwischenschicht aufgebracht wird.
- Selektivität durch von Anfang an unterschiedlich große Ringbreiten der Randklebezone, so dass die Veränderung der Adhäsionskraft der ersten Schicht stärker ausfällt als die Veränderung der Adhäsionskraft der zweiten Schicht durch die oben beschriebenen Maßnahmen.

Die starren Trägerwafer sind vorzugsweise durch eine hohe Verbindungssteifigkeit gekennzeichnet. Als Material sind, auch in Kombinationen, Silicon, Quarz, Glas, Keramik oder Metall besonders geeignet.

Vor oder während des selektiven Ablösens beziehungsweise Abtrennens eines der beiden Trägerwafer wird daher die diesem Trägerwafer zugeordnete Zwischenschicht beziehungsweise die in der Zwischenschicht vorgesehene Adhäsionsschicht durch chemische, thermische und/oder mechanische Eigenschaften der Adhäsionsschicht oder Einflussnahme so stark geändert, dass man den Trägerwafer schonend und beschädigungsfrei entfernen kann, während der Produktwafer auf dem anderen Trägerwafer bleibt. Der andere Trägerwafer stabilisiert dabei den Produktwafer gleichzeitig.

Chips im Sinne der vorliegenden Erfindung sind jegliche Strukturen beziehungsweise integrierte elektronische Bauelemente, die üblicherweise auf Wafer aufgebracht werden. Bumps beziehungsweise Bump-Gruppen dienen der Anbindung der Chips an den Produktwafer beziehungsweise die elektronische Verbindung einzelner Schaltkreise des Chips mit auf der gegenüberliegenden Seite des Produktwafers aufgebrachten korrespondierenden Chips beziehungsweise Schaltkreisen und/oder für die spätere Montage des gesamten Systems auf eine Leiterplatte.

Durch das erfindungsgemäße Verfahren kann nicht nur ein Produktwafer, insbesondere doppelseitig, mit Chips bestückt werden, sondern das erfindungsgemäße Verfahren ist insbesondere für Stapel von, insbesondere jeweils doppelseitig, mit Chips bestückten Produktwafern von besonderem Vorteil, da durch das selektive Entfernen der Trägerwafer ein schonendes und effektives sowie flexibles Verfahren zur Herstellung von gestapelten Produktwafern angegeben wird.

Das Bearbeiten des Produktwafers umfasst einen oder mehrere bekannte Prozesse, nämlich das Aufbringen von Chips auf die zweite Seite und optional auch das Aufbringen von Bumps und/oder Bump-Gruppen auf die zweite Seite und/oder das Rückdünnen/Schleifen des Produktwafers, sowie das Herstellen sogenannter Redistribution Layer (RDL). Produktwafer im Sinne der vorliegenden Erfindung umfassen auch sogenannte Silicon Imposer, die nur Verdrahtungsschichten (RDL Layer) aufweisen, um später Chips mit aktiven Strukturen aufzunehmen.

Erfindungsgemäß ist vorgesehen, dass die Bondkraft der ersten Adhäsionsschicht kleiner ist als die Bondkraft der zweiten Adhäsionsschicht. Mit Bondkraft ist die durch die jeweilige Zwischenschicht zwischen dem Produktwafer und dem Trägerwafer wirkende Verbindungskraft oder Adhäsionskraft gemeint, die einer Trennung des Trägerwafers vom jeweiligen Produktwafer entgegenwirkt, jeweils bezogen auf die wirksame Bondfläche/Adhäsionsfläche. Der Unterschied zwischen der Bondkraft der ersten Adhäsionsschicht und der Bondkraft der zweiten Adhäsionsschicht ist erfindungsgemäß mit Vorteil so groß, dass beim Ablösen des ersten Trägerwafers vom Produktwafer der zweite Trägerwafer mit dem Produktwafer verbunden bleibt.

Indem die erste Adhäsionsschicht kleinere Abmessungen als die zweite Adhäsionsschicht, nämlich eine kleinere Kontaktfläche der Adhäsionsschicht mit dem ersten Trägerwafer und dem Produktwafer und optional zusätzlich eine dünnere Schichtdicke, aufweist, kann die Erfindung allein durch Wahl der geometrischen Ausgestaltung umgesetzt werden, sodass sogar in ihren chemischen Eigenschaften identische Zwischenschichten beziehungsweise Zwischenschichten aus demselben Material eingesetzt werden können.

Gemäß einer weiteren, vorteilhaften Ausführungsform der Erfindung ist vorgesehen, dass zusätzlich die erste Adhäsionsschicht von der zweiten Adhäsionsschicht derart unterschiedliche chemische Eigenschaften aufweist, dass die erste Adhäsionsschicht von einem ersten Lösungsmittel zumindest teilweise aufgelöst wird, während die zweite Adhäsionsschicht in Bezug auf das erste Lösungsmittel zumindest überwiegend inert ist. Auf diese Weise wird die Erfindung durch die chemischen Eigenschaften der Adhäsionsschichten beziehungsweise Zwischenschichten umgesetzt. Mit anderen Worten: Die Selektivität der Lösungsmittel erlaubt eine gezielte Auflösung definierter Bereiche, insbesondere Randbereiche, der jeweiligen Adhäsionsschicht oder Zwischenschicht, also eine selektive Verkleinerung der wirksamen Adhäsionsfläche/Bondfläche.

Dabei ist es von Vorteil, wenn das Verhältnis der Auflöserate A₁ des ersten Lösungsmittels gegenüber der ersten Adhäsionsschicht zu der Auflöserate A₂ des zweiten Lösungsmittels gegenüber der zweiten Adhäsionsschicht kleiner 1:3, insbesondere kleiner 1:10, vorzugsweise kleiner 1:20, noch bevorzugter kleiner 1:100 ist.

Soweit die Abtrennung des ersten Trägerwafers von dem Produktwafer zusätzlich bei steigender Temperatur aufgrund unterschiedlicher thermischer Eigenschaften der ersten Zwischenschicht und der zweiten Zwischenschicht vor der Abtrennung des zweiten Trägerwafers erfolgt, lässt sich die Erfindung in vorteilhafter Weise durch Temperaturregelung umsetzen. Die Adhäsionsschichten unterscheiden sich bei dieser Ausführungsform in ihren thermischen Eigenschaften, nämlich der Viskosität in Abhängigkeit der Temperatur. Der zuerst abzulösende Trägerwafer ist mit einer Zwischenschicht mit einem Kleber gebondet, der bei einer bestimmten Temperatur eine niedrigere Viskosität aufweist als der andere Trägerwafer. Der abzulösende Trägerwafer ist dann durch Abscheren zerstörungsfrei abtrennbar.

Für das Verständnis der beanspruchten Erfindung wird offenbart, dass die Abtrennung des ersten Trägerwafers von dem Produktwafer selektiv aufgrund unterschiedlicher optischer Eigenschaften der ersten und zweiten Verbindungsschichten, insbesondere in Bezug auf die Wirkung von definierten Lichtwellenlängen und/oder definierten Lichtintensitäten, erfolgen kann. Hier wird das selektive Ablösen beziehungsweise Abtrennen durch das Einstrahlen von Licht gesteuert. Das Licht besitzt dabei zwei charakteristische physikalische Parameter, nämlich einerseits die Wellenlänge der Photonen, welche mit der Energie korreliert und die vor allem chemische Vernetzungsprozesse zu steuern vermag und andererseits die Intensität, also die Anzahl der Photonen pro Zeit und Flächeneinheit, die direkt mit der Heizleistung zusammenhängt. Das Material der jeweiligen Adhäsionsschicht weist ein charakteristisches frequenzabhängiges und damit wellenlängenabhängiges Spektrum seiner dielektrischen Eigenschaften auf, was auch als Resonanzspektrum bezeichnet werden kann. Durch die Wahl der entsprechenden Wellenlänge des einfallenden Lichtes können insofern chemische und/oder physikalische Prozesse gesteuert werden.

Einige Polymere vernetzen beispielsweise unter UV-Bestrahlung, wohingegen man Infrarotstrahlung verwenden kann, um Materialien direkt aufzuheizen und damit physikalische Eigenschaften wie beispielsweise die Viskosität gesteuert werden können. Eine lokale Erwärmung der Adhäsionsschicht kann beispielsweise durch Laserlicht erfolgen, was insbesondere bei im Bereich des Umfangs der Zwischenschicht beziehungsweise des Waferumfangs vorgesehener Adhäsionsschicht, also einer ringförmigen Adhäsionsschicht, von Vorteil ist. Besonders vorteilhaft ist es, eine Vernetzung vorzusehen, die durch UV-Beleuchtung aufhebbar ist.

Gemäß einer weiteren, vorteilhaften Ausführungsform der Erfindung ist vorgesehen, dass die Abtrennung des ersten Trägerwafers von dem Produktwafer zusätzlich selektiv aufgrund unterschiedlicher mechanischer Eigenschaften der ersten und zweiten Zwischenschicht erfolgt, in Bezug auf deren Scherfestigkeit. Die Zwischenschicht mit der geringeren Scherfestigkeit bringt einer von außen angelegten Schubkraft einen geringeren Widerstand entgegen, sodass der von dieser Zwischenschicht am Produktwafer befestigte Trägerwafer sich vor dem gegenüberliegenden Trägerwafer löst beziehungsweise lösen lässt. Die Adhäsion wird überwiegend durch Van-der-Waals Kräfte bewirkt.

Die Abtrennung des Trägerwafers durch Abscheren ist durch Kombination mit einer Temperaturbehandlung weiter optimierbar, insbesondere bei Verwendung von thermoplastischen Klebern als Verbindungsmittel, die unterschiedliche Viskositätsverläufe in Abhängigkeit der Temperatur haben.

Soweit die Dicke B₁ der ersten Zwischenschicht oder ersten Adhäsionsschicht größer ist als die Dicke B₂ der zweiten Zwischenschicht oder zweiten Adhäsionsschicht, wird durch diese Maßnahme die erforderliche Scherkraft zum Abtrennen des ersten Trägerwafers verringert, insbesondere bei einem Verhältnis B₁/B₂ von 3/2, vorzugsweise 2/1, noch bevorzugter 3/1, idealerweise 4/1, wobei die zweite, nicht oder anschließend zu lösende Zwischenschicht eine Dicke B₂ von 15 bis 50 µm, vorzugsweise 20 bis 40 µm noch bevorzugter 25 bis 30 µm aufweist.

Erfindungsgemäß ist vorgesehen, dass die erste und die zweite Adhäsionsschicht ringförmig im Bereich des Umfangs des Produktwafers ausgebildet sind. Auf diese Weise kann die Adhäsionsschicht vom Umfang her bearbeitet werden, was insbesondere bei Anwendung von Lösungsmitteln von Vorteil ist, da das Lösungsmittel in diesem Fall nur über eine sehr kurze Strecke diffundieren muss.

In vorteilhafter Weise ist gemäß einer weiteren Ausführungsform der Erfindung vorgesehen, dass die erste Zwischenschicht, insbesondere innerhalb der ringförmigen Adhäsionsschicht, einen Film mit geringer Adhäsionswirkung und/oder die zweite Zwischenschicht einen, insbesondere innerhalb der ringförmigen Adhäsionsschicht angeordneten, Film mit geringer Adhäsionswirkung umfasst. Geringe Adhäsionswirkung ist in Relation zu der Adhäsionswirkung der Adhäsionsschicht gemeint, die insbesondere mindestens zweimal, vorzugsweise mindestens dreimal, noch bevorzugter mindestens fünfmal, idealerweise mindestens zehnmal stärker ist. Die Relation ist bezogen auf die Adhäsionswirkung im dynamischen Zustand, also während dem Abtrennprozess, insbesondere aber zusätzlich bezogen auf den statischen Zustand, also vor dem Abtrennprozess. Der Film kann gemäß einer Ausführungsform der vorliegenden Erfindung als eine Teilbeschichtung der ersten und/oder zweiten Zwischenschicht beziehungsweise ersten und/oder zweiten Adhäsionsschicht vorgesehen sein, wobei die Teilbeschichtung zu einer Verringerung der Adhäsionswirkung führt, insbesondere als Antihaftbeschichtung. Wesentlich ist dabei, dass der Film einen Teil der wirksamen Kontaktfläche der jeweiligen Zwischenschicht mit dem entsprechenden Trägerwafer in der Adhäsionswirkung reduziert.

Eine Vorrichtung weist geeignete Mittel zur Ausübung des vorbeschriebenen, erfindungsgemäß vorgesehenen Verfahrens auf, nämlich Selektivtrennmittel zur selektiven Trennung des ersten Trägerwafers von dem Produktwafer aufgrund der unterschiedlichen Eigenschaften der ersten Zwischenschicht von der zweiten Zwischenschicht. Für die mechanische Trennung, beispielsweise durch Aufbringen von entgegengesetzten Zugkräften am ersten Trägerwafer und am zweiten Trägerwafer jeweils vom Produktwafer weg oder jeweils einer Schubkraft am ersten Trägerwafer und am zweiten Trägerwafer in entgegengesetzter Richtung entlang des Produktwafers kann auf bekannte Vorrichtigungen zurückgegriffen werden. Die Selektivtrennmittel sind jedoch derart ausgebildet, dass geeignete Einrichtungen für die selektive Trennung vorgesehen sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in Schnittansicht:
- Fig. 1: einen Produktwafer in einem ersten, erfindungsgemäßen Verfahrensschritt,
- Fig. 2: einen Produktwafer in einem zweiten, erfindungsgemäßen Verfahrensschritt,
- Fig. 3: einen Produktwafer in einem dritten, erfindungsgemäßen Verfahrensschritt,
- Fig. 4: einen Produktwafer in einem vierten, erfindungsgemäßen Verfahrensschritt,
- Fig. 5: einen Produktwafer in einem fünften, erfindungsgemäßen Verfahrensschritt,
- Fig. 6: einen Produktwafer in einem sechsten, erfindungsgemäßen Verfahrensschritt,
- Fig. 7: einen Produktwafer in einem siebten, erfindungsgemäßen Verfahrensschritt,
- Fig. 8: einen Produktwafer in einem achten, erfindungsgemäßen Verfahrensschritt,
- Fig. 9: einen Produktwafer in einem neunten, erfindungsgemäßen Verfahrensschritt,
- Fig. 10: einen Produktwafer in einem zehnten, erfindungsgemäßen Verfahrensschritt,
- Fig. 11: einen Produktwafer in einem alternativen, nicht zum beanspruchten Gegenstand gehörenden siebten Verfahrensschritt und
- Fig. 12: einen Produktwafer in einem alternativen, siebten erfindungsgemäßen Verfahrensschritt.

In den Figuren sind gleiche Bauteile und Bauteile mit gleicher Funktion mit den gleichen Bezugszeichen gekennzeichnet.

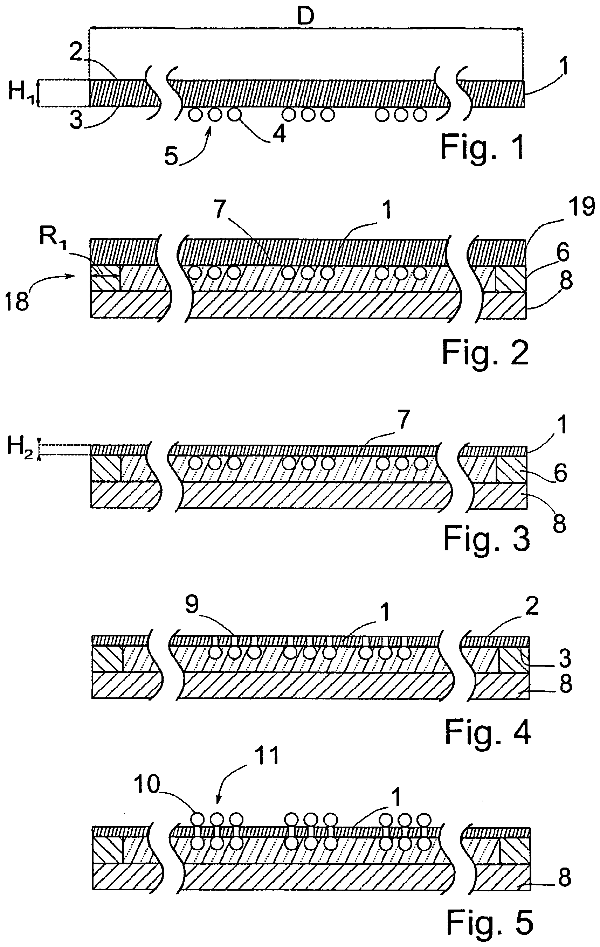

In Figur 1 ist ein zu diesem Zeitpunkt des Verfahrens noch vergleichsweise dicker Produktwafer 1 gezeigt, der mit Bumps 4 beziehungsweise aus den Bumps 4 gebildeten Bump-Gruppen 5 bestückt wird. Der Produktwafer 1 ist zu diesem Zeitpunkt aufgrund seiner Dicke H₁ relativ stabil und insofern ohne Hilfsmittel in sich relativ stabil. Die Anzahl der Bumps 4 und deren Position innerhalb einer Bump-Gruppe 5 hängen von dem jeweiligen Chip 15 (auch als Dice bezeichnet) ab, der in einem späteren Verfahrensschritt (siehe 4 und 9) auf die Bumps 4 aufgebracht wird.

Der Produktwafer 1 hat eine erste Seite 3 und eine zweite Seite 2, wobei die Bumps 4 beziehungsweise Bump-Gruppen 5 in dem ersten Verfahrensschritt gemäß Figur 1 auf die erste Seite 3 aufgebracht werden. Die Aufbringung erfolgt in einer Art und Weise, wie sie im Stand der Technik bekannt ist.

Im zweiten Verfahrensschritt gemäß Figur 2 wird der Produktwafer 1 zur Stabilisierung mit seiner ersten Seite 3 temporär an einen ersten Trägerwafer 8 gebondet, wobei zum Bonden eine erste Zwischenschicht 18 verwendet wird. Die erste Zwischenschicht 18 besteht bei der hier gezeigten Ausführungsform aus einer ersten Adhäsionsschicht 6 und einem ersten Film 7, wobei die erste Adhäsionssicht 6 zum Bonden und der Film 7 zum Einbetten der Bumps 4 dient. Die Figuren 1 bis 12 zeigen jeweils einen Querschnitt und bei den hier gezeigten Ausführungsbeispielen ist der Produktwafer 1 als Kreisscheibe mit einem Durchmesser D von 300 Millimeter ausgebildet. Der Produktwafer 1 kann aber auch eine beliebige andere Scheibenform und einen anderen Durchmesser D aufweisen.

Die erste Adhäsionsschicht 6 ist bei der in Figur 2 gezeigten erfindungsgemäßen Ausführungsform im Bereich eines seitlichen Waferumfangs 19 angeordnet und erstreckt sich vom Waferumfang 19 um einen Bruchteil des Durchmessers D, mit einer Ringbreite R₁ von weniger als ein zehntel, nach innen, sodass sich bei der gezeigten Ausführungsform ein ringförmiger Körper für die erste Adhäsionsschicht 6 ergibt. Das Verhältnis R₁/D beträgt insbesondere weniger als 1/20, vorzugsweise weniger als 1/30, noch bevorzugter weniger als 1/60, noch bevorzugter weniger als 1/120. Die Ringbreite R₁ beträgt insbesondere weniger als 15 mm, vorzugsweise weniger als 10 mm, noch bevorzugter weniger als 5 mm, noch bevorzugter weniger als 2 mm. Innerhalb des ringförmigen Körpers ist der Film 7 angeordnet und dieser ist vollständig umschlossen von dem Produktwafer 1, der ersten Adhäsionsschicht 6 und dem ersten Trägerwafer 8.

Der Film 7 ist gemäß einem nicht zum beanspruchten Gegenstand gehörenden Beispiel als Teilbeschichtung der ersten Adhäsionsschicht 6 vorgesehen, wobei sich die Adhäsionsschicht 6 bei diesem nicht gezeigten alternativen Beispiel über den gesamten ersten Trägerwafer 8 erstreckt. Die Teilbeschichtung ist in den Abmessungen analog dem in Figur 2 gezeigten Film 7 vorgesehen.

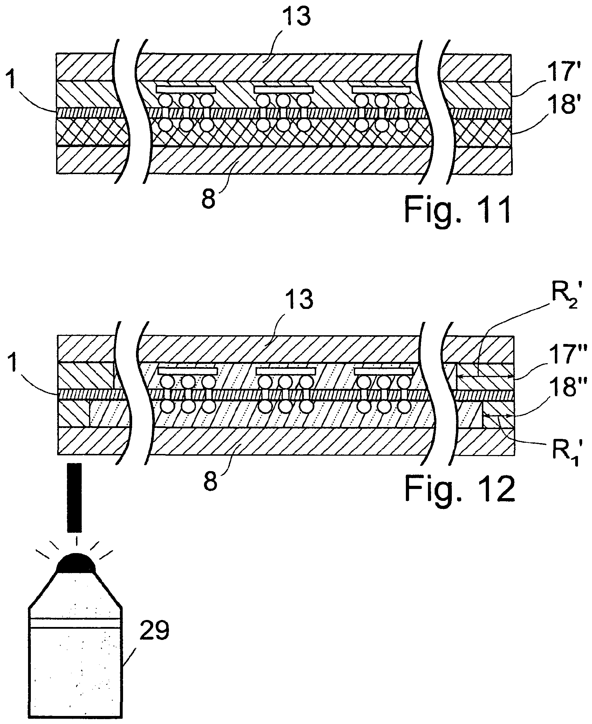

Im Falle eines nicht zum beanspruchten Gegenstand gehörenden Beispiels gemäß Figur 11 ist die erste Zwischenschicht 18' aus einem einzigen Material gebildet und erstreckt sich über die gesamte Fläche des Produktwafers 1. In diesem Fall ist die erste Zwischenschicht 18' in ihrer Adhäsionsfähigkeit von der Temperatur abhängig, sodass bei steigender Temperatur die Adhäsionsfähigkeit, also die Bondkraft abnimmt, insbesondere durch Verringerung der Viskosität, so dass der Kleber eine verminderte Widerstandsfähigkeit gegenüber Scherkräften aufweist.

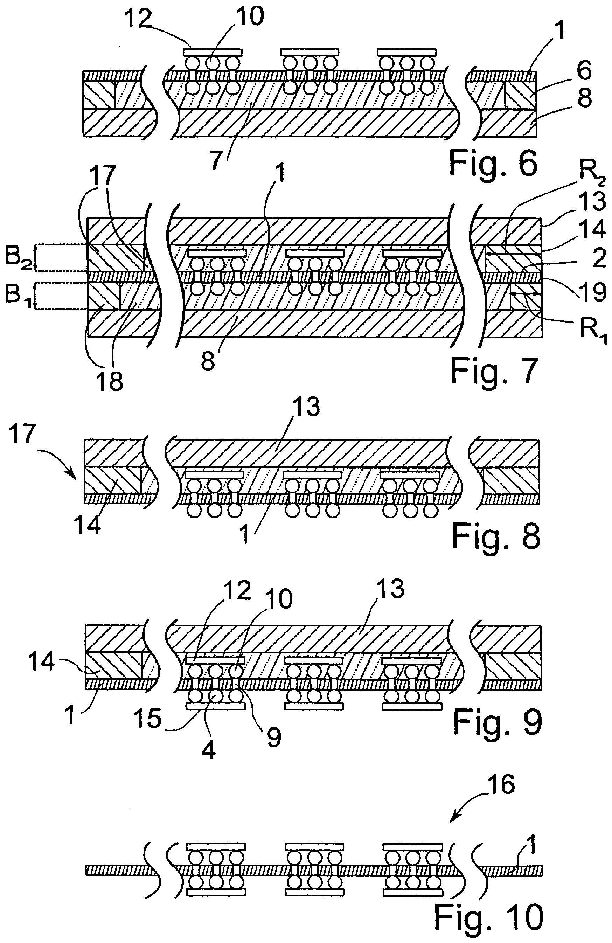

In dem ersten erfindungsgemäßen Verfahrensschritt gemäß Figur 3 wird der Produktwafer 1 durch bekannte Verfahren rückgedünnt von seiner ursprünglichen Dicke H₁ gemäß Figur 1 auf eine dem Endprodukt gemäß Figur 10 entsprechende Dicke H₂ kleiner 150 µm, insbesondere kleiner 100 µm, vorzugsweise kleiner 70 µm, noch bevorzugter kleiner 50 µm, noch bevorzugter kleiner 30, noch bevorzugter kleiner 20 µm.

In dem in Figur 4 gezeigten vierten Verfahrensschritt werden den Produktwafer 1 durchsetzende VIAs 9 in den Produktwafer 1 geätzt, um eine elektrische Verbindung von der ersten Seite 3 zur zweiten Seite 2 zwischen den Bumps 4 und in einem fünften Verfahrensschritt gemäß Figur 5 auf der zweiten Seite 2 aufzubringenden Bumps 10 beziehungsweise Bump-Gruppen 11 zu schaffen.

In einem sechsten Verfahrensschritt gemäß Figur 6 werden Chips 12 auf die zugehörigen Bumps 10 beziehungsweise Bump-Gruppen 11 aufgebracht.

Einer der erfindungsgemäß entscheidenden Verfahrensschritte ist der in Figur 7 dargestellte siebte Verfahrensschritt, in welchem die zweite Seite 2 analog dem in Figur 2 beschriebenen Verfahrensschritt über eine zweite Zwischenschicht 17, die sich in mindestens einer relevanten Eigenschaft von der ersten Zwischenschicht 18 unterscheidet, mit einem zweiten Trägerwafer 13 gebondet wird.

Die zweite Zwischenschicht 17 besteht bei dieser Ausführungsform aus einer zweiten Adhäsionsschicht 14, die sich ebenfalls vom seitlichen Waferumfang 19 des Produktwafers 1 über einen Bruchteil des Durchmessers D, mit einer Ringbreite R₂ bis maximal ein zehntel des Durchmessers D erstreckt. In der vorliegenden Ausführungsform ist die zweite Adhäsionsschicht 14 als Kreisring mit einer Ringbreite R₂ ausgebildet, die größer als die Ringbreite R₁ der ersten Adhäsionsschicht 6 ist. Das Verhältnis R₁/R₂ liegt zwischen 1/10 und 9/10, insbesondere zwischen 1/5 und 4/5, vorzugsweise zwischen 1/4 und 3/4, noch bevorzugter zwischen 1/3 und 2/3. Das Verhältnis R₂/D beträgt insbesondere weniger als 1/20, vorzugsweise weniger als 1/30, noch bevorzugter weniger als 1/60, noch bevorzugter weniger als 1/120. Die Ringbreite R₂ beträgt insbesondere weniger als 15 mm, vorzugsweise weniger als 10 mm, noch bevorzugter weniger als 5 mm, noch bevorzugter weniger als 2 mm.

Auf diese Weise ergibt sich eine größere wirksame Adhäsionsfläche/Bondfläche bei der zweiten Adhäsionsschicht 14 zwischen dem Produktwafer 1 und dem zweiten Trägerwafer 13.

In einer mit der vorliegenden Ausführungsform kombinierbaren Ausführungsform der Erfindung ist die Dicke B₁ der ersten Zwischenschicht 18 größer als die Dicke B₂ der zweiten Zwischenschicht 17, insbesondere im Verhältnis B₁/B₂ von mindestens 3/2, vorzugsweise 2/1, noch bevorzugter 3/1, idealerweise mindestens 4/1.

In einem achten Verfahrensschritt gemäß Figur 8 wird der erste Trägerwafer 8 durch Reduzierung der Bondkraft der ersten Adhäsionsschicht 6 und Anlegen einer von dem Produktwafer 2 weg gerichteten Zugkraft abgelöst. Die Reduzierung der Bondkraft ist bereits implementiert und kann optional zusätzlich in einem früheren Verfahrensschritt erfolgt sein. Alternativ kann der zweite Trägerwafer 8 durch entgegengesetzt wirkende Scherkräfte am ersten und zweiten Trägerwafer 8, 13 parallel zum Produktwafer 1 abgeschert werden. Eine weitere Alternative besteht im Abschälen (peel off) des Trägerwafers, beginnend von dessen Rand. Beim Abschälen wird der Trägerwafer an dessen Rand elastisch verbogen, wodurch das Fortschreiten der Trennfront vom Rand beginnend zum Zentrum des Trägerwafers hin und anschließend zum gegenüberliegenden Rand hin erfolgt, während der zweite Trägerwafer und der Produktwafer auf einer Auflage fixiert werden, um einer Verbiegung des zweiten Trägerwafers und des Produktwafers entgegenzuwirken. Das Abtrennen kann in einer vorteilhaften Ausführungsform durch mechanische Trennung, insbesondere durch Einbringen eines mechanischen Elements an eine Stelle am Umfangsrand der Zwischenschicht, erfolgen. Das mechanische Element kann beispielsweise ein flacher Keil sein.

Aufgrund der größeren Adhäsionsfläche und der insofern stärkeren Bondkraft der zweiten Adhäsionsschicht 14 gegenüber der ersten Adhäsionsschicht 6 wird automatisch der erste Trägerwafer 8 abgelöst. Soweit beim Ablösen noch Reste des Films 7 oder der Adhäsionsschicht 6 an dem Produktwafer 2 verbleiben, können diese durch einen Reinigungsschritt entfernt werden. In der in Figur 7 und 8 gezeigten Ausführungsform ist der erste Trägerwafer 8 demnach aufgrund der geometrischen Ausgestaltung, also wegen der größeren Adhäsionsfläche der zweiten Adhäsionsschicht 14 abgelöst worden. In dem in Figur 11 gezeigten alternativen, nicht zum beanspruchten Gegenstand gehörenden Beispiel weist die erste Zwischenschicht 18' unterschiedliche thermische Eigenschaft zu der zweiten Zwischenschicht 17' derart auf, dass die erste Zwischenschicht 18' ihre Adhäsionskraft beziehungsweise Bondkraft schneller verringert als die zweite Zwischenschicht 17'.

Gemäß einer bevorzugten Ausführungsform der Erfindung ist der Verfahrensablauf wie folgt:
- Bonden des Produktwafers 1 mit seiner ersten Seite 3 auf einem ersten, starren Trägerwafer 8 mit einer ersten Zwischenschicht 18 bestehend aus einer randseitig aufgebrachten ersten Adhäsionsschicht,
- zumindest teilweises Lösen der ersten Adhäsionsschicht 6,
- Bonden des Produktwafers 1 mit seiner zweiten Seite 2 auf einem zweiten, starren Trägerwafer 13 mit einer zweiten Zwischenschicht 17 bestehend aus einer randseitig aufgebrachten zweiten Adhäsionsschicht 14 und
- Abtrennen des ersten Trägerwafers, insbesondere durch Anlegen entgegengesetzt wirkender Scherkräfte an dem ersten Trägerwafer 8 und dem zweiten Trägerwafer 13 parallel zum Produktwafer 1 oder durch Abschälen des ersten Trägerwafers 8.

Die erste und zweite Adhäsionsschicht 6, 14 sind vorzugsweise aus demselben Material und über die gesamte Fläche der jeweiligen Trägerwafer verteilt, wobei an der jeweiligen Bondfläche/Adhäsionsfläche der Adhäsionsschichten zum jeweiligen Trägerwafer erste und zweite Teilbeschichtungen der ersten und zweiten Adhäsionsschichten 6, 14 aufgebracht sind, um in dem Bereich der Aufbringung eine deutliche Reduzierung der Adhäsionskraft zu erreichen.

In der in Figur 12 gezeigten alternativen Ausführungsform ist die erste Adhäsionsschicht 18" analog der Ausführungsform gemäß Figur 7 mit einer kleineren Ringbreite R1' als die Ringbreite R2' der zweiten Adhäsionsschicht 17" ausgebildet, sodass durch eine Lichtquelle 29 auf die erste Adhäsionsschicht 18" und zweite Adhäsionsschicht 17" eingewirkt wird, soweit es sich bei beiden Adhäsionsschichten 17", 18" um das gleiche Material handelt. Aufgrund der größeren Ringbreite R2' der zweiten Adhäsionsschicht 17" ist der erste Trägerwafer 8 vor dem zweiten Trägerwafer 13 ablösbar, zumal die Lichtquelle 29 mit Vorteil relativ punktuell wirkend ausgebildet ist. Es kann sich dabei beispielsweise um eine UV-Lichtquelle handeln.

Alternativ können die erste Adhäsionsschicht 18"und die zweite Adhäsionsschicht 17" gegenüber unterschiedlichen Lichtintensitäten/Lichtfrequenzen reagierend ausgebildet sein.

Den vorbeschriebenen Ausführungsformen und Beispielen ist gemein, dass die erste Adhäsionsschicht 18, 18', 18" unterschiedlich zur zweiten Adhäsionsschicht 17, 17', 17" ist derart, dass bei entsprechender Einwirkung eine geringere Adhäsionskraft beziehungsweise Bondkraft zwischen dem Produktwafer 1 und dem ersten Trägerwafer 8 im Vergleich zu der Adhäsionskraft beziehungsweise Bondkraft zwischen dem Produktwafer 1 und dem zweiten Trägerwafer 13 wirkt.

In dem in Figur 9 gezeigten neunten Verfahrensschritt werden analog dem sechsten Verfahrensschritt gemäß Figur 6 Chips 15 auf die Bumps 4 aufgebracht und damit elektrisch leitend mit den Chips 12 verbunden.

Nach Ablösen des zweiten Trägerwafers 13 in einem zehnten Verfahrensschritt gemäß Figur 10 verbleibt ein doppelseitig bestückter Produktwafer 16. Soweit Stapel von Produktwafern 16 erzeugt werden sollen, kann nach dem neunten Verfahrensschritt gemäß Figur 9 eine praktisch beliebige Zahl von mit Chips 12, 15 bestückten Produktwafern 1 gestapelt werden, wobei jeweils die N-te Adhäsionsschicht eine kleinere Bondkraft beim Ablösen aufweisen muss als die N+1-te Adhäsionsschicht. Das heißt, dass analog der oben beschriebenen Verfahrensweise die Modifikation der N-ten Adhäsionsschicht/Zwischenschicht entweder direkt beim Ablösen des N-ten Trägerwafers oder vor dem Ablösen den N-ten Trägerwafers, insbesondere vor dem Bonden des N+1-ten Trägerwafers erfolgt.

Statt des Films 7 kann der von dem Film 7 ausgefüllte Bereich alternativ mit Gas gefüllt oder evakuiert werden.

Die in den Figuren 1 bis 9 gezeigte Ausführungsform wird in vorteilhafter Weise durch chemische Lösungsmittel beim Lösen der ersten und zweiten Adhäsionsschicht 6, 14 unterstützt. Es sind demnach Kombinationen aus chemischen, thermischen, optischen und mechanischen Verfahrensschritten zum Lösen der Adhäsionsschichten möglich.

Bei nicht zum beanspruchten Gegenstand gehörenden Methoden mit ganzflächigen Zwischenschichten, wie beispielsweise in Figur 11 gezeigt, eignen sich eher optische und/oder thermische Lösungsmethoden, während die Anwendung von Lösungsmittel wegen der Diffusionszeit vom Waferumfang 19 her weniger geeignet erscheint.

### Bezugszeichenliste

- 1: Produktwafer
- 2: zweite Seite
- 3: erste Seite
- 4: Bumps
- 5: Bump-Gruppen
- 6: erste Adhäsionsschicht
- 7: Film
- 8: erster Trägerwafer
- 9: VIAs
- 10: Bumps
- 11: Bump-Gruppen
- 12: Chips
- 13: zweiter Trägerwafer
- 14: zweite Adhäsionsschicht
- 15: Chips
- 16: doppelseitig bestückter Produktwafer
- 17, 17', 17": zweite Zwischenschicht
- 18, 18', 18": erste Zwischenschicht
- 19: Waferumfang
- 29: Lichtquelle
- D: Durchmesser
- H₁: Waferdicke
- H₂: Waferdicke
- R₁, R₁': Ringbreite
- R₂, R₂': Ringbreite
- B₁: Dicke der Zwischenschicht
- B₂: Dicke der Zwischenschicht

## Patentansprüche

1. Verfahren zur Herstellung eines Produktwafers (1) mit folgendem Ablauf:
- Bearbeiten einer ersten Seite (3) des Produktwafers (1),
- Bonden des Produktwafers (1) mit seiner ersten Seite (3) auf einem ersten, starren Trägerwafer (8) mit einer ersten Zwischenschicht (18, 18") bestehend aus einer randseitig aufgebrachten ersten Adhäsionsschicht (6), die sich vom seitlichen Waferumfang (19) des Produktwafers (1) mit einer ersten Ringbreite R₁ kleiner als ein Zehntel des Durchmessers D des Produktwafers (1) als ringförmiger Körper nach innen erstreckt,
- Bearbeiten einer der ersten Seite (3) gegenüberliegenden zweiten Seite (2) des Produktwafers (1) durch Bestücken der zweiten Seite mit Chips (12) und
- Bonden des Produktwafers (1) mit seiner zweiten Seite (2) auf einem zweiten, starren Trägerwafer (13) mit einer zweiten Zwischenschicht (17, 17") bestehend aus einer randseitig aufgebrachten zweiten Adhäsionsschicht (14), die sich vom seitlichen Waferumfang (19) des Produktwafers (1) mit einer zweiten Ringbreite R₂ kleiner als ein Zehntel des Durchmessers D des Produktwafers (1) als ringförmiger Körper nach innen erstreckt, wobei die zweite Ringbreite R₂ größer als die erste Ringbreite R₁ der ersten Adhäsionsschicht (6) ist, wodurch die erste Zwischenschicht (18, 18") und die zweite Zwischenschicht (17, 17") derart unterschiedlich mit einer von Beginn an stärkeren Bondkraft der zweiten Zwischenschicht (17, 17") ausgebildet sind, dass der erste Trägerwafer (8) selektiv vor dem zweiten Trägerwafer (13) von dem Produktwafer (1) abtrennbar ist.

2. Verfahren nach Anspruch 1, bei dem die erste Adhäsionsschicht (6) größere Abmessungen als die zweite Adhäsionsschicht (14), nämlich eine dickere Schichtdicke, aufweist.

3. Verfahren nach einem der vorhergehenden Ansprüche, bei dem die erste Adhäsionsschicht (6) von der zweiten Adhäsionsschicht (14) zusätzlich derart unterschiedliche chemische Eigenschaften aufweist, dass die erste Adhäsionsschicht (6) von einem ersten Lösungsmittel zumindest teilweise aufgelöst wird, während die zweite Adhäsionsschicht (14) in Bezug auf das erste Lösungsmittel zumindest überwiegend inert ist, so dass die selektive Abtrennung des ersten Trägerwafers (8) vor der Abtrennung des zweiten Trägerwafers (13) bewirkt werden kann.

4. Verfahren nach einem der vorhergehenden Ansprüche, bei dem die erste Zwischenschicht (18, 18") von der zweiten Zwischenschicht (17, 17") zusätzlich derart unterschiedliche thermische Eigenschaften aufweist, dass die erste Zwischenschicht (18, 18") bei steigender Temperatur auf Grund der niedrigeren Viskosität zumindest teilweise aufgelöst wird, so dass die selektive Abtrennung des ersten Trägerwafers (8) vor der Abtrennung des zweiten Trägerwafers (13) bewirkt werden kann.

5. Verfahren nach einem der vorhergehenden Ansprüche, bei dem die Abtrennung des ersten Trägerwafers (8) von dem Produktwafer (1) zusätzlich selektiv aufgrund unterschiedlicher mechanischer Eigenschaften der ersten Zwischenschicht (18, 18") und der zweiten Zwischenschicht (17, 17") in Bezug auf die Scherfestigkeit erfolgt.

6. Verfahren nach einem der vorhergehenden Ansprüche, bei dem zwischen dem ersten Trägerwafer (8) und der ersten Zwischenschicht (18, 18") eine erste, insbesondere auf dem ersten Trägerwafer (8) aufgebrachte, Teilbeschichtung zur Reduzierung der Bondkraft/Adhäsionskraft im Bereich der ersten Teilbeschichtung und/oder zwischen dem zweiten Trägerwafer (13) und der zweiten Zwischenschicht (17, 17") eine zweite, insbesondere auf dem zweiten Trägerwafer (13) aufgebrachte, Teilbeschichtung zur Reduzierung der Bondkraft/Adhäsionskraft im Bereich der zweiten Teilbeschichtung aufgebracht wird.

## Claims

1. Method for producing a product wafer (1), which proceeds as follows:
- processing of a first side (3) of the product wafer (1)
- bonding of the product wafer (1) with its first side (3) on a first rigid carrier wafer (8) with a first intermediate layer (18, 18") consisting of a first adhesion layer (6) applied on the edge side, which extends inwards from the lateral wafer periphery (19) of the product wafer (1) with a first annular width R₁ smaller than a tenth of diameter D of the product wafer (1) as an annular body,
- processing of a second side (2) of the product wafer (1) lying opposite the first side (3) by providing the second side with chips (1) and
- bonding of the product wafer (1) with its second side (2) on a second rigid carrier wafer (13) with a second intermediate layer (17, 17") consisting of a second adhesion layer (14) applied on the edge side, which extends inwards from the lateral wafer periphery (19) of the product wafer (1) with a second annular width R₂ smaller than a tenth of diameter D of the product wafer (1) as an annular body, wherein the second annular width R₂ is greater than the first annular width R₁ of the first adhesion layer (6), as a result of which the first intermediate layer (18, 18") and the second intermediate layer (17, 17") are made different with a from the start greater bonding force of the second intermediate layer (17, 17"), such that the first carrier wafer (8) can be separated selectively before the second carrier wafer (13) from the product wafer (1).

2. The method as claimed in Claim 1, wherein the first adhesion layer (6) has larger dimensions than the second adhesion layer (14), i.e. a thicker layer thickness.

3. The method as claimed in one of the preceding Claims, wherein the first adhesion layer (6) also has chemical properties different from the second adhesion layer (14) such that the first adhesion layer (6) is at least partially dissolved by a first solvent, while the second adhesion layer (14) is at least largely inert with reference to the first solvent, so that the selective separation of the first carrier wafer (8) can be effected before separation of the second carrier wafer (13).

4. The method as claimed in one of the preceding Claims, wherein the first intermediate layer (18, 18") also has thermal properties different from the second intermediate layer (17, 17") such that the first intermediate layer (18, 18") with rising temperature is at least partially dissolved on account of the lower viscosity, so that the selective separation of the first carrier wafer (8) can be effected before separation of the second carrier wafer (13).

5. The method as claimed in one of the preceding Claims, wherein the separation of the first carrier wafer (8) from the product wafer (1) also takes place selectively as a result of different mechanical properties of the first intermediate layer (18, 18") and the second intermediate layer (17, 17") in relation to the shear strength.

6. The method as claimed in one of the preceding Claims, wherein between the first carrier wafer (8) and the first intermediate layer (18, 18") a first partial coating applied especially on the first carrier wafer (8) is applied for reducing the bonding force/adhesion force in the region of the first partial coating and/or between the second carrier wafer (13) and the second intermediate layer (17, 17") a second partial coating applied especially on the second carrier wafer (13) is applied for reducing the bonding force/adhesion force in the region of the second partial coating.

## Revendications

1. Procédé de production d'une tranche de produit (1) comprenant le déroulement suivant :
- traitement du premier côté (3) de la tranche de produit (1),
- collage de la tranche de produit (1) par son premier côté (3) sur une première tranche porteuse (8) fixe avec une première couche intermédiaire (18, 18") composée d'une première couche d'adhérence (6) appliquée sur la périphérie, qui s'étend vers l'intérieur en tant que corps annulaire à partir du pourtour de tranche (19) latéral de la tranche de produit (1) avec une première largeur annulaire R₁ inférieure à un dixième du diamètre D de la tranche de produit (1),
- traitement d'un deuxième côté (2) de la tranche de produit (1) opposé au premier côté (3) par garnissage du deuxième côté avec des puces (12) et
- collage de la tranche de produit (1) par son deuxième côté (2) sur une deuxième tranche porteuse (13) fixe avec une deuxième couche intermédiaire (17, 17") composée d'une deuxième couche d'adhérence (14) appliquée sur la périphérie, qui s'étend vers l'intérieur en tant que corps annulaire à partir du pourtour de tranche (19) latéral de la tranche de produit (1) avec une deuxième largeur annulaire R₂ inférieure à un dixième du diamètre D de la tranche de produit (1), dans lequel la deuxième largeur annulaire R₂ est plus grande que la première largeur annulaire R₁ de la première couche d'adhérence (6), ce par quoi la première couche intermédiaire (18, 18") et la deuxième couche intermédiaire (17, 17") sont ainsi conçues de manière différente avec une force de collage de la deuxième couche intermédiaire (17, 17") plus forte dès le départ de sorte que la première tranche porteuse (8) peut être séparée de manière sélective de la tranche de produit (1) avant la deuxième tranche porteuse (13).

2. Procédé selon la revendication 1, dans lequel la première couche d'adhérence (6) présente des dimensions supérieures à la deuxième couche d'adhérence (14), à savoir une épaisseur de couche plus épaisse.

3. Procédé selon l'une des revendications précédentes, dans lequel la première couche d'adhérence (6) présente en outre des propriétés chimiques différentes de la deuxième couche d'adhérence (14) de telle sorte que la première couche d'adhérence (6) est dissoute au moins partiellement par un premier solvant, tandis que la deuxième couche d'adhérence (14) est au moins majoritairement inerte par rapport au premier solvant de façon à ce que la séparation sélective de la première tranche porteuse (8) puisse être effectuée avant la séparation de la deuxième tranche porteuse (13).

4. Procédé selon l'une des revendications précédentes, dans lequel la première couche intermédiaire (18, 18") présente en outre des propriétés chimiques différentes de la deuxième couche intermédiaire (17, 17") de telle sorte que la première couche intermédiaire (18, 18") est dissoute au moins partiellement lorsque la température augmente du fait de viscosité moindre de façon à ce que la séparation sélective de la première tranche porteuse (8) puisse être effectuée avant la séparation de la deuxième tranche porteuse (13).

5. Procédé selon l'une des revendications précédentes, dans lequel la séparation de la première tranche porteuse (8) de la tranche de produit (1) s'effectue en outre de manière sélective en raison de propriétés mécaniques différentes de la première couche intermédiaire (18, 18") et de la deuxième couche intermédiaire (17, 17") par rapport à la résistance au cisaillement.

6. Procédé selon l'une des revendications précédentes, dans lequel est appliqué entre la première tranche porteuse (8) et la la première couche intermédiaire (18, 18"), un premier revêtement partiel, appliqué en particulier sur la première tranche porteuse (8), pour réduire la force de collage/force d'adhérence au niveau du premier revêtement partiel et/ou est appliqué entre la deuxième tranche porteuse (13) et la deuxième couche intermédiaire (17, 17"), un deuxième revêtement partiel, appliqué en particulier sur la deuxième tranche porteuse (13) pour réduire la force de collage/force d'adhérence au niveau du deuxième revêtement partiel.
